# EUROPEAN PATENT SPECIFICATION

(11) **EP 4 630 775 B1**
(45) Date of publication and mention of the grant of the patent: **16.09.2026**
(21) Application number: 23833305.8
(22) Date of filing: 08.12.2023
(51) Int. Cl.: G01M 5/00, G01M 11/08, G01R 31/08

(54) **A POWER CABLE HEALTH MONITORING METHOD**
ENERGIEKABELGESUNDHEITSÜBERWACHUNGSVERFAHREN
PROCÉDÉ DE SURVEILLANCE D'ÉTAT DE CÂBLE D'ALIMENTATION

(30) Priority: 08.12.2022 GB 202218513
(43) Date of publication of application: 15.10.2025
(73) Proprietor: Indeximate Ltd, Hinkley Leicestershire LE10 1AQ (GB)
(72) Inventor: GODFREY, Alastair, Fleet Hampshire GU51 3NE (GB); MINTO, Chris DG, Leicestershire LE10 1AQ (GB)
(74) Representative: FRKelly
(86) International application number: PCT/EP2023/085003
(87) International publication number: WO 2024/121429

(56) References cited:
- WO-A1-2016/151298
- WO-A1-2018/154275
- KR-A- 20160 036 175

## Description

### Technical Field

The present invention relates to the identification of mechanical faults in electrical power cables using signals provided by fibre optic cables which are mechanically coupled with the power cable.

### Background

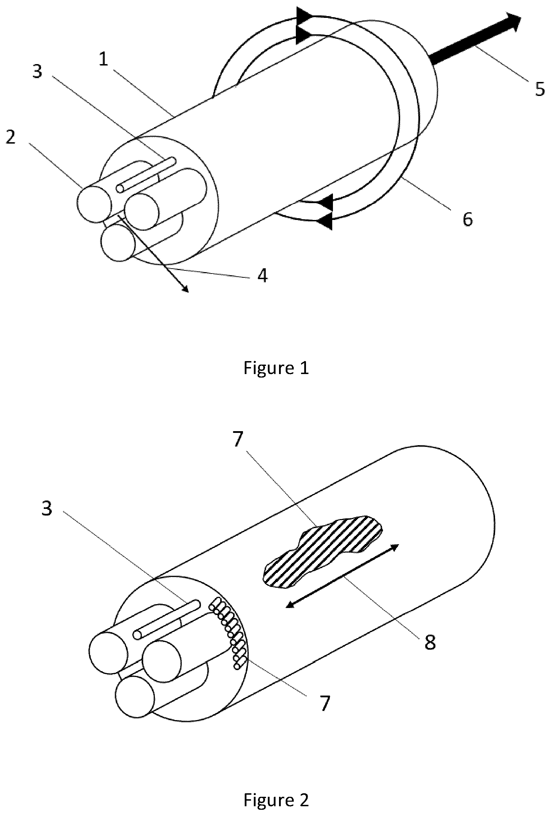

Electrical transmission power cables are important and expensive pieces of infrastructure, and their failure is expensive to locate and repair. This is especially true for buried and subsea power cables. Typically, the failure process is slow. The outer covering may become abraded or damaged by impacts, then wear or corrosion of the armour wires begins to occur. As shown in Fig. 2, the outer covering can wear so that the armour wires (7) are exposed. Fatigue may also be an issue, with heavily loaded strands of the armour wire (7) breaking and transferring stress to other wires in an ever-increasing cycle to failure.

If this gradual degradation of the cable can be detected measures can be put in place which slow down or prevent this process. This detection is difficult, and often the first that is known about this gradual failure process is when catastrophic failure has occurred. It may be understood by one skilled in the art that the construction of high voltage transmission lines is complex, with water blocking, shielding, strengthening, packing and conducting components (2). This needs to be considered in the discussion below on measurement of strain within the cable, and how that strain relates to the gradual failure of the cable.

WO2016151298 discloses methods and apparatus for determining the location of a fault in a power cable of a power distribution network. WO2018154275 discloses methods and apparatus for monitoring of subsea cables, for example subsea power or telecommunication cables, and in particular to determining a burial status for such cables. KR20160036175 relates to a fault monitoring system and a fault monitoring method of a photoelectric cable assembly.

One method of measuring strain within a power cable is the use of distributed fibre optic sensing. This is especially accessible for this application since many of the power cables already in existence have fibre optic cables contained within the cable structure for other purposes. There are several different fibre sensing approaches to measuring strain, however any of these approaches that takes more than approximately 10 seconds to make a measurement (for example Distributed Strain Sensing, DSS) has very limited use due to the nature of the fibre cable construction. The fibres within the power cables are typically of 'loose tube' construction. This means that over longer timescales they are not well coupled to the mechanical strain state of the power cable.

Rayleigh backscatter approaches can be used to sensitively measure change in strain state very rapidly (> 1000 times per second). This approach is generally known as Distributed Acoustic Sensing or DAS and is the most applicable to the methodology described below. However, one skilled in the art will understand that other fibre sensing approaches could be used, for example Fibre Bragg Gratings or high speed DSS and the use of DAS for the examples below is not intended to limit the idea to DAS. It is also possible that special cables could be designed in which the fibre is well coupled mechanically to the cable structure. This type of fibre optic cable is known as 'tight buffered', and this construction is equally applicable to the invention proposed below.

Power cables are generally constructed with a loose tube arrangement of fibres. In these circumstances, only change in strain can realistically be used for cable analysis. There is some prior art in which DAS has been used to measure strain change within a power cable to determine some information about the cable, for example burial depth or bends. An example of dynamic strain related measurements that have been made on comparable structures are on the cabling for suspension bridges. Here the acoustic signature of the failure of individual strands within the load-bearing cable can be picked up with microphones or DAS, and this approach may also work for sub-sea cables. This signal is transient in nature and could be difficult to measure in a noisy sub-sea environment for example. This is not the method being presented here.

The power cable experiences forces from a variety of sources in the environment, but the forces being used in this disclosure originate from the electrical current being carried by the cable itself. In a three-phase cable the current flow is not unidirectional, but the electrical power (5) is delivered in a single direction. The forces of interest here are related to the frequency of the current variations within the cable. This frequency will be referred to as the fundamental frequency, Fo, and is typically 50 or 60 Hz in AC power cables. In cables carrying DC current, although the current is always in one direction (unlike AC cables) there is also a variation in the amplitude of the current at a known frequency. This is typically 100 or 120 Hz. Both AC and DC cables are appropriate for the invention below to be exploited and the analysis of AC examples is not intended to limit the idea to AC.

In a cable carrying multiple conductors, there will be a force between any two of those conductors if they are both carrying current (the magnetic force). For known currents and cable dimensions, this force is very well defined and easily calculated. For a typical 3-core AC cable, it transpires that there are radial (4) and tangential forces (6) acting on individual conductors, and this force gets transmitted to the fibre (if present) vibrationally in some complex, but detectable, way. The radial and tangential forces express themselves as axial strain in a way determined by the effective Poisson ratio of the overall cable structure.

It may be expected that the magnitude of this strain transmission to the fibre may change if the cable is bent or otherwise deformed, and this has been the subject of a previous patent application. It is important to understand that all of these magnetic forces have a minimum frequency of twice the fundamental frequency. Higher harmonics at n times twice the fundamental frequency, where n is a positive integer, will exist due to distortion originating from the non-linear nature of the deformation within the cable, but no signal on the fibre at the fundamental frequency is expected. Also, no component of the magnetic force is in the axial direction.

The current within the cable can also generate an internal force by another mechanism: magnetostriction of the cable armouring - this will create a smaller measurement signal than that arising from the current forces.

Magnetostriction is a magnetic effect that can occur in ferromagnetic materials where the dimensions of the material depend on the local strength of the magnetic field. This is due to the rotation of magnetic domains within the material as a field is applied and occurs effectively instantaneously. The steel armour wire (7) present in most power cables happens to show this property of magnetostriction and is the main load bearing component of the cable. The use of steel armour (7) to detect magnetic field changes in a fibre optic cable has been the subject of a previous patent. The magnetostrictive effect is symmetrical about magnetic field, B, = 0, and so an alternating current of the fundamental frequency would be expected to generate a magnetostrictive strain of frequency 2 x the fundamental frequency when no bias field is present. Magnetostrictive strain of the armour would transmit a predominantly axial strain (8) to the fibre through the power cable structure. The detectable signal at twice the fundamental frequency will be a sum of all these individual contributions vibrating in unison at that frequency (10) in response to the force experienced by the fibre from the relationship between each conductor (9).

In this specification, a frequency which is twice the fundamental frequency (or first harmonic frequency) is referred to as the second harmonic frequency.

### Statements of Invention

According to a first aspect of the present invention, there is provided a power cable health monitoring method for determining degradation in the mechanical properties of electrical power cables with distributed fibre optic sensing, the method including:
- receiving an input signal from an optical fibre coupled with an electrical power cable, wherein the electrical power cable is carrying an electrical current in the presence of a biasing magnetic field and wherein the input signal is a measurement of strain on the optical fibre;
- receiving an electrical current signal from the electrical current, which has a fundamental frequency;
- measuring a first characteristic of the input signal at the fundamental frequency of the electrical current signal and/or odd harmonics thereof and measuring a second characteristic of the input signal on the optical fibre at twice the fundamental frequency of the electrical current signal or relevant harmonics thereof, and wherein the measured characteristics are either amplitudes or phases;
- extracting numerical values of the first and second characteristics;
- generating a degradation ratio which is a ratio of the first and second characteristic numerical values;
- providing an output signal which comprises the degradation ratio over time.

Possibly, the input signal comprises a plurality of channel input signals. Possibly, each channel input signal is a measurement of strain at a different specific location along the length of the optical fibre. Possibly, one first and one second characteristic is measured for each channel input signal. Possibly, numerical values are extracted, and one degradation ratio is generated for each specific location. Possibly, the output signal includes one degradation ratio for each specific location along the length of the optical fibre over time.

Possibly, the biasing magnetic field is the ambient field from the Earth.

Possibly, the biasing magnetic field originates from passive, accidental or deliberate magnetisation of components of the cable.

Possibly, the biasing magnetic field originates from a net current flow in the cable being analysed.

Possibly, the bias magnetic field is generated externally to the cable. Possibly, a reference current signal is used to increase gain of the fundamental frequency of the current signal.

Possibly, the reference current signal is from another sensor, which may be another optical fibre, which may be associated with or coupled with the electrical power cable.

Possibly, the reference current signal is a current signal from one specific location along the length of the optical fibre.

Possibly, the first and second characteristics are amplitudes.

Possibly, the amplitudes are normalised by the electrical current signal.

Possibly, the fundamental frequency is measured at each location to provide a locationspecific fundamental frequency signal.

Possibly, the amplitudes are normalised relative to either or both of an average of all of the location-specific fundamental frequency signals and/or an average of the location-specific second harmonic frequency signals.

Possibly, the amplitudes are normalised relative to a selected one or more of the locationspecific fundamental frequency signals and/or the location-specific second harmonic frequency signals.

Possibly, each of the fundamental and the second harmonic frequency signals has an amplitude. Possibly, the amplitudes of the fundamental and second harmonic frequency signals are first normalised at each specific location by the amplitude at (fundamental frequency)-m and (2 x fundamental frequency)-m respectively in which m represents a small frequency shift to a location away from electrically dominant frequencies to subtract background noise contributions.

Possibly, the contribution from the Earth's magnetic field is first subtracted leaving local induced variations.

Possibly, the degradation ratio increases with degradation of the electrical power cable. Possibly, the degradation ratio reaches a predetermined degradation ratio alert level, the output signal activates an alert. Possibly, the amplitudes are summed over a plurality of time periods to improve signal to noise ratio. The time periods may be tidal time periods.

According to another aspect of the present invention, there is provided a computer program [product] comprising instructions which, when the program is executed by a computer, cause the computer to carry out the method of the preceding statement.

According to another aspect of the present invention, there is provided a computer- readable medium having stored thereon the computer program [product] of the preceding statement.

Possibly, the method includes any of the features or steps described in any of the preceding statements or following description.

### Figures

Embodiments of the present invention will now be described, by way of example only, and with reference to the accompanying drawings, in which:-
**Figure 1****:** An electrical power cable (1) includes three copper conductors (2) on which three electrical phases are carried and a monitoring fibre optic cable (3). Transmittal of electrical power (5) will generate a circumferential magnetic field (6) and generate forces both tangentially (6) and radially (4).
**Figure 2****:** Power cables typically feature steel helical armour comprised of many individual strands (7). In the presence of the varying magnetic field these exhibit the feature of magnetostriction which causes axial forces (8) in the cable which are transferred through coupling to the fibre optic cable (3).

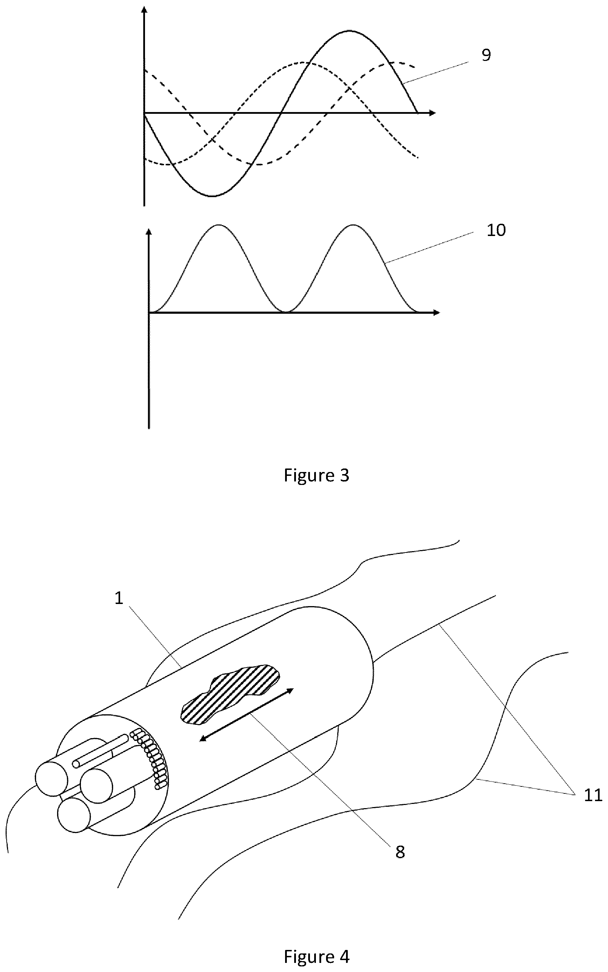

**Figure 3****:** The three-phase power generation will create a magnetic field (9) measured at an arbitrary point on the circumference of the cable from each of the cores. This will generate through the magnetostrictive response a varying strain (10) on the fibre optic cable which features a cyclical response at twice the fundamental frequency of generation.
**Figure 4****:** The cable may experience the presence of a bias field (11) which provides a DC offset to the dynamic magnetic field (shown as the Earth's magnetic field (11) but could additionally be from a range of sources including passive or deliberate magnetisation of the armour) or the presence of external ferromagnetic material.

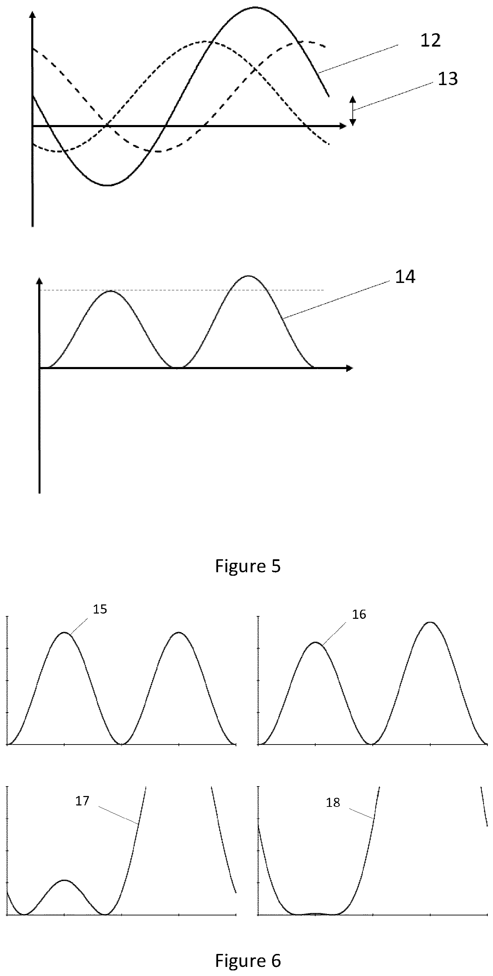

**Figure 5****:** The magnetic field (12) at the surface of the cable is modified by the presence of a DC bias offset (13) and the resulting axial strain from the magnetostriction now experiences both the original double fundamental frequency signal and an additional fundamental frequency component as exhibited in the height difference in the peaks (14).
**Figure 6****:** Varying the strength of the magnetic bias field in a typical cable will alter the axial strain response - free of bias it exhibits twice fundamental frequency behaviour (15), with a bias equivalent to the typical Earth's field (0.05mT) we see the emergence of a fundamental frequency signal (16) which grows stronger as the field increases (16,17) to 0.5mT and 1 mT (17, 18) by additional means such as cable magnetization.

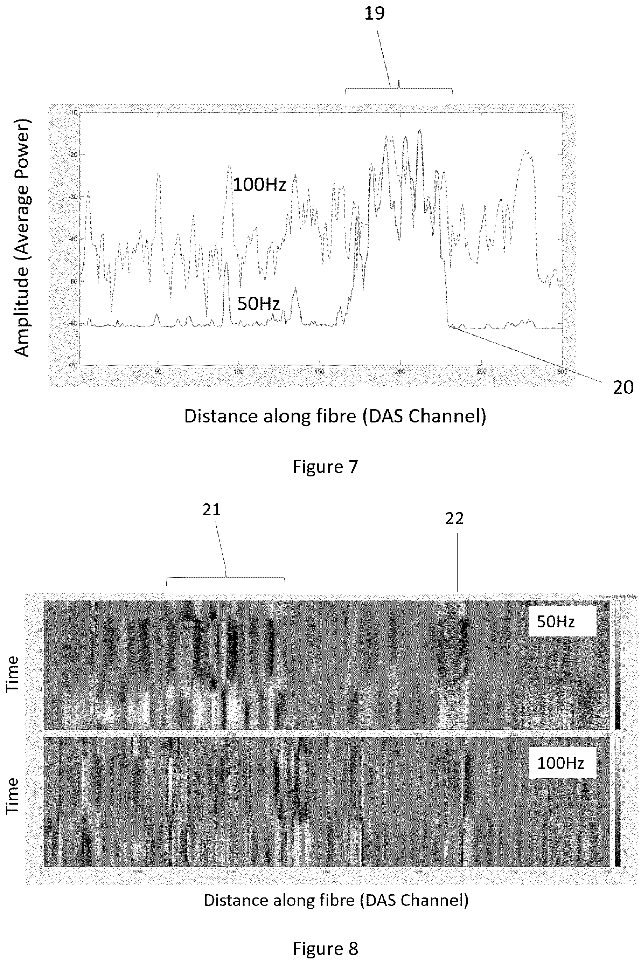

**Figure 7****:** A plot of the amplitude of the fundamental frequency (50 Hz) signal and the second harmonic (100 Hz) signal along the fibre length. There is a section of the cable with joins, junction boxes and ferromagnetic infrastructure (19) where the magnitude of the 50 Hz signal is clearly stronger. The beach begins at channel 230 (20) and the 50 Hz signal is seen to be much lower after this point. The 100Hz signal, although exhibiting complex behaviour, is relatively invariant in comparison.
**Figure 8****:** A plot of the variation over one tidal cycle (12 hours) time of the amplitude of the signal at 50 Hz (top) and 100 Hz (bottom). Two regions are highlighted, an area of freespan (21) and a repaired section of cable (22). In the area of freespan (21) we see a strong 50Hz signal (darker trace) arising between hours 4 and 10 indicating increased levels of armour stress affecting the 50Hz signal. The repair section (22) which was exposed to tidal flow shows similar behaviour. The 100Hz signal is relatively invariant over the period. This indicates static power levels and these results confirm the validity of the inventive method.

In the drawings, where multiple instances of the same or similar features exist, only a representative one or some of the instances of the features have been provided with numeric references for clarity.

### Description

A power cable health monitoring method for determining degradation in the mechanical properties of electrical power cables 1 with distributed fibre optic sensing 3 is disclosed. The method includes receiving an input signal from an optical fibre 3 coupled with an electrical power cable 1 , which is carrying an electrical current 5 in the presence of a biasing magnetic field 11. The input signal is a measurement of strain on the optical fibre. The method includes receiving an electrical current signal from the electrical current, which has a fundamental frequency; measuring a first characteristic of the input signal at the fundamental frequency of the electrical current signal and/or odd harmonics thereof and measuring a second characteristic of the input signal on the optical fibre at the second harmonic frequency of the electrical current signal or relevant harmonics thereof. The measured characteristics are either amplitudes or phases. The method includes extracting numerical values of the first and second characteristics; generating a degradation ratio which is a ratio of the first and second characteristic numerical values; and providing an output signal which comprises the degradation ratio over time.

The inventors have realised that if a local magnetic bias field is present the magnetic asymmetry (12) caused would lead to an additional fundamental frequency component (14) of the dynamic strain signal that is measured on the fibre. If present, this fundamental frequency signal would be solely related to axial cable forces. Calculations and measurements have revealed that bias fields of varying origin and strength exist in practical cables. This is partly due to the Earth's magnetic field (11) and partly from any residual or induced magnetism of the steel.

The inventors have further realised that the magnitude of the magnetostrictive strain is strongly dependent on the axial tensile stress of the armour wires. Any change to the fundamental frequency strain signal (measured as either an amplitude or measurement of phase) implies a change in either the bias field or the tensile stress of the armour wires (cable strength members). Since the amplitude of the signal at double the fundamental frequency (ie the second harmonic frequency) is largely unaffected by the state of bias, the change in the ratio of the signals at frequencies of 1 and 2 times the fundamental frequency can be used as an indicator of the change in axial strain state. This ratio is referred to as the degradation ratio since it can be used to indicate the degradation of the condition of the electrical cable. Usefully, a higher degradation ratio indicates increased degradation of the electrical power cable.

The order of the ratio will provide differing perspectives on the interplay of forces as will ratios involving higher harmonics of the fundamental.

The mechanism by which the tensile loading of the armour affects the magnitude of the magnetostrictive strain is well documented in the literature. Increasing tensile stress strongly decreases the magnitude of magnetostrictive strain for a given field change. Compressive stress has a much smaller effect. A sudden increase in tensile loading of a section of the cable (from, for example, a failed armour wire) would result in a sudden decrease of the magnetostrictive strain component. This would show up mainly in the fundamental frequency band where this signal is not obscured by other larger factors. This change in signal can be used to inform the power cable owners about highly stressed areas in need of maintenance before cable failure occurs. It will be understood by one skilled in the art that any odd multiple of the fundamental frequency could also be used to track these changes. These harmonics exist due to the non-linearity of the response of the system to magnetic field changes.

Variation in the level of DC bias signal (Figure 6) will cause the fundamental frequency component to be modulated. The example shows representative power transmission circumstances in an increasing bias field from OT (15) to 0.050 mT (16) (approximately equivalent to the Earth's magnetic field) and then on to larger bias of 0.5 mT (17) and 1 mT (18), indicative of some remnant or induced magnetization of the cable. In an installation, the contribution from the earth's magnetic field can be subtracted leaving local induced variations or alternatively trended over time to reveal changing conditions of cable stress.

A number of signal processing methods can be used to extract phase and/or amplitude of either the fundamental frequency signal (eg 50Hz) or harmonics (eg second harmonic (100Hz) etc) from the background noise and to improve the signal to noise ratio.

In one example, one method is to compare the amplitude of the signal in a narrow frequency window around the fundamental frequency with that of the signal from a nearby, but distinctly different, frequency window not associated with electrical transmission activity. This different 'noise' window can then be subtracted from the signal window.

In another example, another method is to compare with a known reference signal. A reference electrical signal is used either from a separate sensor, and/or a defined section of the power cable with embedded fibre, to use for gain of the fundamental frequency of the electrical signal. The amplitude of the signals received from the fibre sensor can be normalised by the known current flowing within the cable. Alternatively, the averaged signal from all or some of the fibre can be used for normalisation.

Another normalisation approach is to take the amplitude of the fundamental and twice the fundamental frequency signals and normalise in each fibre distance segment channel by the amplitude at (fundamental frequency)-m and (2 x fundamental frequency)-m where m represents a small frequency shift to a location away from electrically dominant frequencies to subtract background noise contributions.

Further, the signal to noise ratio may be improved by a stacking process whereby time slices corresponding to a similar expected stimulus (e.g. slice by tidal period to extract tidally induced strain) are summed together. Tidal stacking is one approach, stacking segments experiencing similar current flow or weather is another and this signal-noise ratio gain approach is not limited to tidal stacking.

There are other methods to extract a reference signal, and the examples presented herein should not limit the scope of the invention.

### Example 1

In this first example, data is taken from a live subsea power cable running with a fundamental electrical frequency of 50 Hz. A fibre optic cable is embedded in the power cable structure and a Distributed Acoustic Sensing system is used to extract strain data at all points along the fibre. The measured part of the cable is 30 km long. If the magnitude of the 50 Hz signal from the fibre optic cable is extracted and averaged from about an hour's worth of data, its variation over distance along the fibre can be examined. As shown in Figure 7, this signal changes with position along the cable. The section of the cable from which this data is extracted shows the contrast between cable running on land, where there are several channels with a large signal, these correspond to junction boxes, joins and other ferromagnetic infrastructure which have influenced the local field bias (19). Once the cable runs out to sea from channel 230 (20) these external influences are absent and the 50 Hz signal drops to a much lower level. The amplitude of the 100 Hz signal shows a different pattern since in this case the sensitivity of the cable to radial and tangential forces is of primary importance rather than the local bias fields.

### Example 2

A particular section of the cable described in example 1 was found to be in free span, i.e., unsupported for significant distances on a sub-sea section. During changes in tidal flow speed the stresses on this cable change due to the drag force exerted by the flowing water. Nearby was a section of cable which had been repaired after past failure, this repair lay exposed on the seabed and was thus also subject to forces from the flowing water. In Figure 8 the amplitudes over 12 hours of the 50 Hz and 100 Hz signals from one of the locations in free span (21) and the cable repair (22) are plotted. Whilst the amplitude of the 100 Hz signal is stable during a tidal cycle (~6 hours between high flows), the same cannot be said for the amplitude of the 50 Hz signal. This change in amplitude can be attributed to the change in armour stress, and therefore the magnitude of the magnetostrictive response.

### Example 3

The inventors have also found that the method can utilise signals relating to phase to determine the degradation of power cables.

A change in detected phase of the magnetic signature is directly correlated to a change in the mechanical state of the cable. In a typical trefoil design of power cable, the fibre optic cable should in the same position relative to the electrical conductors along the whole length of the power cable unless the electrical phases or position of the fibre are physically changed.

Each electrical conductor generates a magnetic field which can be indirectly detected using the fibre optic cable, but the magnitude and phase of the effect from each conducting element is different. The phase is carefully maintained at 120 degrees between each conductor during power generation, and the magnitude from each conductor is determined by a number of factors including the distance between the conductor and the fibre optic cable and the contribution of the armour to the total stiffness of the cable.

The overall signal which is detected using the fibre is the sum of these effects from each conductor. The contribution of each conductor to the total detectable signal is strongly dependent on the distance between the conductor and the fibre, so that if this distance changes, the summed signal will also change in both magnitude and phase.

Either magnitude or phase can be used to detect change in the position of the conducting elements relative to the fibre optic cable, but in general and advantageously, phase could be more conducive to extracting a change signal because, unlike magnitude, it is not expected to change over time. This temporal stability means that long averaging times can be used to extract the change signal. This approach means that small deformations of the cable can be detected as a local change in phase relative to the average phase measured from other parts of the cable, either using the fibre optic cable or other sensors. Another aspect which changes the summed total signal which can be detected by the fibre is if armour starts to degrade or break. This will also therefore lead to a change in the phase and magnitude of the detectable signal.

### Invention Discussion

Embodiments of the present invention relate to measurement methods and equipment needed to monitor electrical power cables for mechanical degradation. The degradation is associated with failing strength components of the power cable by fatigue or over stressing. Additionally, or alternatively, the degradation may be due to the reduction in cross sectional area of the strength members by, for example, abrasion or corrosion.

In one embodiment, the Earth's magnetic field is used to provide the magnetic bias. Although this field is small, it is well known. Changes in the direction of the cable relative to the magnetic field would result in a change of bias, and therefore a change in the amplitude of the signal at a fundamental frequency. Following the length of a cable which has a spatially varying path, this will provide a gradually varying background to the fundamental frequency signal proportionate to the local earth's magnetic field which can be normalised to reveal local variations which when compared to the relatively invariant double fundamental frequency signal is dependent on cable distortion, anomalies and tensile stresses.

In a further embodiment current loading of the cable which is axially stressed induces a degree of permanent magnetism in the ferromagnetic armour strands which is spatially tied to locations of maximum strain thereby creating the magnetic bias and thus affecting the fundamental frequency signal.

In some embodiments a bias field may be deliberately created or enhanced, for example by magnetising the armour during deployment. The response of the cable to the magnetic field could also be tailored by the choice of material and processing of the armour.

In one embodiment, the current being carried by the cable itself can generate the bias field. In DC cables, the current itself generates a very significant bias field, and the DC ripple can be used to generate the fundamental frequency strain signal.

In a further embodiment, the electrical current can be measured with separate instrumentation, and the fibre sensing signal correlated to the electrical signal of one of the conductors in the cable for better signal to noise ratio. This methodology is an example of an approach that can also reveal any phase shifts over time, although others exist. Phase shifts can also indicate change in the mechanical state of the cable because this implies the mechanical load is being distributed differently round the circumference of the cable. An alternative approach to using a separate sensor to correlate with the signal is to use the average of all the cable and/or some specifically chosen reference channels. For example, the reference channels may be near the start of the cable close to noisy transformers.

These embodiments described above represent examples of possible methods of exploiting the asymmetry generated with a bias field. One skilled in the art would be able to envisage other methodologies of making use of this effect. These examples should not limit the scope of the invention as defined in the appended claims.

Any of the features or steps of any of the embodiments shown or described could be combined in any suitable way, within the scope of the overall disclosure of this document.

### Final Remarks

There is thus provided a method for monitoring the degradation of inaccessible and remote power cables. The method permits monitoring of degradation over long distances. Advantageously, in some embodiments, no additional hardware in terms of sensors is required apart from that already existing. Furthermore the method provides a simple output to identify a level of degradation.

## Claims

1. A power cable health monitoring method for determining degradation in the mechanical properties of electrical power cables (1) with distributed fibre optic sensing, the method including:
receiving an input signal from an optical fibre (3) coupled with an electrical power cable (1), wherein the electrical power cable is carrying an electrical current (5) in the presence of a biasing magnetic field (11) and wherein the input signal is a measurement of strain on the optical fibre;
receiving an electrical current signal from the electrical current, which has a fundamental frequency; measuring a first characteristic of the input signal at the fundamental frequency of the electrical current signal and/or odd harmonics thereof and measuring a second characteristic of the input signal on the optical fibre at twice the fundamental frequency of the electrical current signal or relevant harmonics thereof, and wherein the measured characteristics are either amplitudes or phases;
extracting numerical values of the first and second characteristics;
generating a degradation ratio which is a ratio of the first and second characteristic numerical values;
providing an output signal which comprises the degradation ratio over time.

2. . A method as claimed in claim 1 , in which the input signal comprises a plurality of channel input signals; each channel input signal is a measurement of strain at a different specific location along the length of the optical fibre; one first and one second characteristic is measured for each channel input signal, numerical values are extracted and one degradation ratio is generated for each specific location, and wherein the output signal includes one degradation ratio for each specific location along the length of the optical fibre over time.

3. . A method as claimed in claims 1 or 2, in which the biasing magnetic field is the ambient magnetic field from the Earth.

4. . A method as claimed in claims 1 or 2, in which the biasing magnetic field originates from passive, accidental or deliberate magnetisation of components of the cable.

5. . A method as claimed in claims 1 or 2, in which the biasing magnetic field originates from a net current flow in the cable being analysed.

6. . A method as claimed in claims 1 or 2, in which the biasing magnetic field is generated externally to the cable.

7. . A method as claimed in any of the preceding claims, in which a reference current signal is used to increase gain of the fundamental frequency of the current signal.

8. . A method according to claim 7, in which the reference current signal is from another sensor, which may be coupled with the electrical power cable.

9. . A method according to claim 7, in which the reference current signal is a current signal from one specific location along the length of the optical fibre.

10. . A method as claimed in any of the preceding claims, in which the first and second characteristics are amplitudes; and the amplitudes are normalised by the electrical current signal.

11. . A method as claimed in claim 2, in which the first and second characteristics are amplitudes; and the fundamental frequency is measured at each location to provide a location-specific fundamental frequency signal.

12. . A method as claimed in claim 11 , in which the amplitudes are normalised relative to either or both of an average of all of the location-specific fundamental frequency signals and/or an average of the location-specific second harmonic frequency signals.

13. . A method as claimed in claim 11, in which the amplitudes are normalised relative to a selected one or more of the location-specific fundamental frequency signals and/or the location-specific second harmonic frequency signals.

14. . A method as claimed in claim 2, in which each of the fundamental and second harmonic frequency signals has an amplitude, and the amplitudes of the fundamental and second harmonic frequency signals are first normalised at each specific location by the amplitude at (fundamental frequency)-m and (2 x fundamental frequency)-m respectively in which m represents a small frequency shift to a location away from electrically dominant frequencies to subtract background noise contributions.

15. . A method as claimed in claim 3 or any claim dependent thereon, in which the contribution from the Earth's magnetic field is first subtracted leaving local induced variations.

16. . A method according to any of the preceding claims, in which the degradation ratio increases with degradation of the electrical power cable.

17. . A method according to any of the preceding claims, in which, when the degradation ratio reaches a predetermined degradation ratio alert level, the output signal activates an alert.

18. . A method according to any of the preceding claims, in which the first and second characteristics are amplitudes and the amplitudes are summed over a plurality of time periods to improve signal to noise ratio.

19. . A computer program [product] comprising instructions which, when the program is executed by a computer, cause the computer to carry out the method of the preceding claims.

20. . A computer-readable medium having stored thereon the computer program [product] of the preceding claim.

## Patentansprüche

1. Energiekabelzustandsüberwachungsverfahren zum Bestimmen einer Verschlechterung der mechanischen Eigenschaften von elektrischen Energiekabeln (1) mit verteilter faseroptischer Abtastung, wobei das Verfahren Folgendes beinhaltet:
Empfangen eines Eingangssignals von einer optischen Faser (3), die mit einem elektrischen Energiekabel (1) gekoppelt ist, wobei das elektrische Energiekabel einen elektrischen Strom (5) in Gegenwart eines Vorspannungsmagnetfelds (11) führt, und wobei das Eingangssignal eine Messung einer Dehnung der optischen Faser ist;
Empfangen eines elektrischen Stromsignals von dem elektrischen Strom, der eine Grundfrequenz aufweist;
Messen eines ersten Merkmals des Eingangssignals bei der Grundfrequenz des elektrischen Stromsignals und/oder der ungeraden Harmonischen davon und Messen eines zweiten Merkmals des Eingangssignals an der optischen Faser bei der doppelten Grundfrequenz des elektrischen Stromsignals oder der relevanten Harmonischen davon, und wobei die gemessenen Merkmale entweder Amplituden oder Phasen sind;
Extrahieren von Zahlenwerten des ersten und zweiten Merkmals;
Erzeugen eines Verschlechterungsverhältnisses, das ein Verhältnis der Zahlenwerte des ersten und zweiten Merkmals ist;
Bereitstellen eines Ausgangssignals, das das Verschlechterungsverhältnis im Laufe der Zeit umfasst.

2. Verfahren nach Anspruch 1, bei dem das Eingangssignal eine Vielzahl von Kanaleingangssignalen umfasst; wobei jedes Kanaleingangssignal eine Dehnungsmessung an einer unterschiedlichen spezifischen Stelle entlang der Länge der optischen Faser ist; wobei für jedes Kanaleingangssignal ein erstes und ein zweites Merkmal gemessen werden, Zahlenwerte extrahiert werden und für jede spezifische Stelle ein Verschlechterungsverhältnis erzeugt wird; und wobei das Ausgangssignal ein Verschlechterungsverhältnis für jede spezifische Stelle entlang der Länge der optischen Faser im Laufe der Zeit beinhaltet.

3. Verfahren nach Anspruch 1 oder 2, bei dem das Vorspannungsmagnetfeld das Umgebungsmagnetfeld der Erde ist.

4. Verfahren nach Anspruch 1 oder 2, bei dem das Vorspannungsmagnetfeld aus passiver, zufälliger oder absichtlicher Magnetisierung von Komponenten des Kabels entsteht.

5. Verfahren nach Anspruch 1 oder 2, bei dem das Vorspannungsmagnetfeld aus einem Nettostromfluss in dem zu analysierenden Kabel entsteht.

6. Verfahren nach Anspruch 1 oder 2, bei dem das Vorspannungsmagnetfeld außerhalb des Kabels erzeugt wird.

7. Verfahren nach einem der vorhergehenden Ansprüche, bei dem ein Referenzstromsignal verwendet wird, um eine Verstärkung der Grundfrequenz des Stromsignals zu erhöhen.

8. Verfahren nach Anspruch 7, bei dem das Referenzstromsignal von einem anderen Sensor ist, der mit dem elektrischen Energiekabel gekoppelt sein kann.

9. Verfahren nach Anspruch 7, bei dem das Referenzstromsignal ein Stromsignal von einer spezifischen Stelle entlang der Länge der optischen Faser ist.

10. Verfahren nach einem der vorhergehenden Ansprüche, bei dem das erste und zweite Merkmal Amplituden sind; und wobei die Amplituden durch das elektrische Stromsignal normiert werden.

11. Verfahren nach Anspruch 2, bei dem das erste und zweite Merkmal Amplituden sind; und die Grundfrequenz an jeder Stelle gemessen wird, um ein stellenspezifisches Grundfrequenzsignal bereitzustellen.

12. Verfahren nach Anspruch 11, bei dem die Amplituden relativ entweder zu einem oder beiden von einem Mittelwert aller der stellenspezifischen Grundfrequenzsignale und/oder einem Mittelwert der stellenspezifischen Frequenzsignale der zweiten Harmonischen normiert werden.

13. Verfahren nach Anspruch 11, bei dem die Amplituden relativ zu einem oder mehreren ausgewählten der stellenspezifischen Grundfrequenzsignale und/oder der stellenspezifischen Frequenzsignale der zweiten Harmonischen normalisiert werden.

14. Verfahren nach Anspruch 2, bei dem jedes der Grundfrequenz- und der Frequenzsignale der zweiten Harmonischen eine Amplitude aufweist und die Amplituden der Grundfrequenz- und der Frequenzsignale der zweiten Harmonischen an jeder spezifischen Stelle zunächst durch die Amplitude bei (Grundfrequenz)-m beziehungsweise (2 x Grundfrequenz)-m normiert werden, wobei m eine kleine Frequenzverschiebung zu einer Stelle weg von elektrisch dominanten Frequenzen darstellt, um Beiträge eines Hintergrundrauschens zu subtrahieren.

15. Verfahren nach Anspruch 3 oder einem davon abhängigen Anspruch, bei dem zunächst der Beitrag des Erdmagnetfeldes subtrahiert wird, wobei lokale induzierte Variationen verbleiben.

16. Verfahren nach einem der vorhergehenden Ansprüche, bei dem das Verschlechterungsverhältnis mit der Verschlechterung des elektrischen Energiekabels zunimmt.

17. Verfahren nach einem der vorhergehenden Ansprüche, bei dem das Ausgangssignal, wenn das Verschlechterungsverhältnis eine vorbestimmte Verschlechterungsverhältniswarnstufe erreicht, eine Warnung auslöst.

18. Verfahren nach einem der vorhergehenden Ansprüche, bei dem das erste und zweite Merkmal Amplituden sind und die Amplituden über eine Vielzahl von Zeiträumen summiert werden, um das Signal-Rausch-Verhältnis zu verbessern.

19. Computerprogramm[produkt], umfassend Anweisungen, die, wenn das Programm durch einen Computer ausgeführt wird, den Computer veranlassen, das Verfahren nach den vorhergehenden Ansprüchen durchzuführen.

20. Computerlesbares Medium, aufweisend darauf gespeichert das Computerprogramm[produkt] des vorhergehenden Anspruchs.

## Revendications

1. Procédé de surveillance de l'état de câbles d'alimentation pour déterminer la dégradation des propriétés mécaniques des câbles d'alimentation électrique (1) avec détection distribuée par fibre optique, le procédé comportant :
la réception d'un signal d'entrée provenant d'une fibre optique (3) couplée à un câble d'alimentation électrique (1), dans lequel le câble d'alimentation électrique transporte un courant électrique (5) en présence d'un champ magnétique de polarisation (11) et dans lequel le signal d'entrée est une mesure de la déformation sur la fibre optique ;
la réception d'un signal de courant électrique provenant du courant électrique, lequel possède une fréquence fondamentale ;
la mesure d'une première caractéristique du signal d'entrée à la fréquence fondamentale du signal de courant électrique et/ou à des harmoniques impaires de celle-ci, et la mesure d'une seconde caractéristique du signal d'entrée sur la fibre optique à deux fois la fréquence fondamentale du signal de courant électrique ou d'harmoniques pertinents de celle-ci, et dans lequel les caractéristiques mesurées sont soit des amplitudes, soit des phases ;
l'extraction des valeurs numériques des première et seconde caractéristiques ;
la génération d'un taux de dégradation qui est un rapport entre les première et seconde valeurs numériques caractéristiques ;
l'émission d'un signal de sortie qui comprend le taux de dégradation au fil du temps.

2. Procédé selon la revendication 1, dans lequel le signal d'entrée comprend une pluralité de signaux d'entrée de canal ; chaque signal d'entrée de canal est une mesure de la déformation à un emplacement spécifique différent le long de la fibre optique ; une première et une seconde caractéristique sont mesurées pour chaque signal d'entrée de canal, des valeurs numériques sont extraites et un taux de dégradation est généré pour chaque emplacement spécifique, et dans lequel le signal de sortie comporte un taux de dégradation pour chaque emplacement spécifique le long de la fibre optique au fil du temps.

3. Procédé selon les revendications 1 ou 2, dans lequel le champ magnétique de polarisation est le champ magnétique ambiant de la Terre.

4. Procédé selon les revendications 1 ou 2, dans lequel le champ magnétique de polarisation provient d'une magnétisation passive, accidentelle ou délibérée des composants du câble.

5. Procédé selon les revendications 1 ou 2, dans lequel le champ magnétique de polarisation provient d'un flux de courant net dans le câble analysé.

6. Procédé selon les revendications 1 ou 2, dans lequel le champ magnétique de polarisation est généré à l'extérieur du câble.

7. Procédé selon l'une quelconque des revendications précédentes, dans lequel un signal de courant de référence est utilisé pour augmenter le gain de la fréquence fondamentale du signal de courant.

8. Procédé selon la revendication 7, dans lequel le signal de courant de référence provient d'un autre capteur, qui peut être couplé au câble d'alimentation électrique.

9. Procédé selon la revendication 7, dans lequel le signal de courant de référence est un signal de courant provenant d'un emplacement spécifique le long de la fibre optique.

10. Procédé selon l'une quelconque des revendications précédentes, dans lequel les première et seconde caractéristiques sont des amplitudes ; et les amplitudes sont normalisées par le signal de courant électrique.

11. Procédé selon la revendication 2, dans lequel les première et seconde caractéristiques sont des amplitudes ; et la fréquence fondamentale est mesurée à chaque emplacement pour fournir un signal de fréquence fondamentale spécifique à l'emplacement.

12. Procédé selon la revendication 11, dans lequel les amplitudes sont normalisées par rapport à l'une ou l'autre d'une moyenne de tous les signaux de fréquence fondamentale spécifiques à l'emplacement et/ou d'une moyenne des signaux de fréquence du second harmonique spécifiques à l'emplacement, ou aux deux.

13. Procédé selon la revendication 11, dans lequel les amplitudes sont normalisées par rapport à un ou plusieurs signaux sélectionnés parmi les signaux de fréquence fondamentale spécifiques à l'emplacement et/ou les signaux de fréquence du second harmonique spécifiques à l'emplacement.

14. Procédé selon la revendication 2, dans lequel chacun des signaux de fréquence fondamentale et du second harmonique ont une amplitude, et les amplitudes des signaux de fréquence fondamentale et du second harmonique sont d'abord normalisées à chaque emplacement spécifique par l'amplitude à (fréquence fondamentale)-m et (2 x fréquence fondamentale)-m respectivement, dans lequel m représente un petit décalage de fréquence vers un emplacement éloigné des fréquences électriquement dominantes pour soustraire les contributions du bruit de fond.

15. Procédé selon la revendication 3 ou toute revendication qui en dépend, dans lequel la contribution du champ magnétique de la Terre est d'abord soustraite, laissant subsister les variations induites locales.

16. Procédé selon l'une quelconque des revendications précédentes, dans lequel le taux de dégradation augmente avec la dégradation du câble d'alimentation électrique.

17. Procédé selon l'une quelconque des revendications précédentes, dans lequel, lorsque le taux de dégradation atteint un niveau d'alerte de taux de dégradation prédéterminé, le signal de sortie active une alerte.

18. Procédé selon l'une quelconque des revendications précédentes, dans lequel les première et seconde caractéristiques sont des amplitudes et les amplitudes sont sommées sur une pluralité de périodes de temps pour améliorer le rapport signal sur bruit.

19. [Produit de] programme informatique, comprenant des instructions qui, lorsque le programme est exécuté par un ordinateur, amènent l'ordinateur à mettre en œuvre le procédé selon les revendications précédentes.

20. Support lisible par ordinateur sur lequel est stocké le [produit de] programme informatique de la revendication précédente.
